# EUROPÄISCHE PATENTSCHRIFT

(11) **EP 0 580 663 B1**
(45) Veröffentlichungstag und Bekanntmachung des Hinweises auf die Patenterteilung: **04.01.1995**
(21) Anmeldenummer: 92908193.3
(22) Anmeldetag: 07.04.1992
(51) Int. Cl.: G06F 17/50

(54) **VERFAHREN ZUR VERIFIKATION DATENVERARBEITENDER SYSTEME**
PROCEDURE FOR VERIFYING DATA-PROCESSING SYSTEMS
PROCEDE POUR LA VERIFICATION DE SYSTEMES TRAITANT DES DONNEES

(30) Priorität: 17.04.1991 EP 91106157
(43) Veröffentlichungstag der Anmeldung: 02.02.1994
(73) Patentinhaber: SIEMENS AKTIENGESELLSCHAFT, 80333 München (DE)
(72) Erfinder: FILKORN, Thomas, D-80337 München (DE)
(86) Internationale Anmeldenummer: EP9200789
(87) Internationale Veröffentlichungsnummer: WO9218944

(56) Entgegenhaltungen:
- PROCEEDINGS OF THE IMEC-IFIP INTERNATIONAL WORKSHOP ON APPLIED FORMAL METHODS FOR CORRECT VLSI DESIGN 13-16 NOVEMBER 1989 HOUTHALEN BELGIUM Seiten 111 - 128; COUDERT ET AL: 'VERIFICATION OF SEQUENTIEL MACHINES USING BOOLEAN FUNCTIONAL VECTORS'
- IEEE INTERNATIONAL CONFERENCE ON COMPUTER-AIDED DESIGN 11-15 NOVEMBER 1990 SANTA CLARA US Seiten 126 - 129; COUDERT: 'A UNIFIED FRAMEWORK FOR THE FORMAL VERIFICATION OF SEQUENTIAL CIRCUITS'

## Beschreibung

Fehler in der Entwurfsphase digitaler Schaltungen sind ein Hauptgrund für unerwartete Verzögerungen und zusätzliche Kosten. Um diese zu vermeiden, werden momentan verschiedene Simulationsverfahren zur Verifikation eines logischen Schaltungsentwurfs eingesetzt. Unglücklicherweise wächst die Zahl der zur Verifikation einer Schaltung oder eines datenverarbeitenden Systems nötigen Simulationen exponentiell mit der Zahl der Eingänge kombinatorischer Schaltkreise und sogar schneller für sequentielle Schaltkreise, da bei diesen alle möglichen Eingangssequenzen zu simulieren sind. Obwohl solche Methoden zur Simulation digitaler Schaltungen weit verbreitet sind und einen wichtigen Platz im Entwurfsprozeß solcher Schaltungen einnehmen, sind sie weit davon entfernt zur vollständigen Überprüfung und Verifikation von Schaltungen geeignet zu sein, weshalb die Richtigkeit einer Schaltung, d.h. die Übereinstimmung zwischen ihrer tatsächlichen Implementierung und ihrer Entwurfsspezifikation nicht garantiert werden kann. Aus diesem Grunde sind formale Verifikationsmethoden jeder Art von Simulation vorzuziehen, da diese im Prinzip die vollständige Richtigkeit einer Schaltung beweisen können.

Spezifikationen von kombinatorischen oder synchronen sequentiellen Schaltungen werden häufig in Form sog. Hardware-Beschreibungssprachen (hardware description languages, HDL) formuliert. In solchen Fällen bedeutet die formale Verifikation den Vergleich einer digitalen Schaltung, wie sie z.B. in Form einer Netzliste gegeben ist mit ihrer Spezifikation in Form einer Beschreibung mit den Methoden einer Hardware-Beschreibungssprache. Aus der Literatur (Erik Tidén, Richard Schmid, "Verifying ASICs bei symbolic simulation", in EURO ASIC 90, 1990) sind formale Schaltkreisverifikationswerkzeuge bekannt, deren Anwendbarkeit aber auf kombinatorische Schaltkreise beschränkt ist. Die formale Verifikation sequentieller Digitalschaltungen ist wesentlich schwieriger, und es sind nur wenige Ansätze zu einer Lösung des Problems der Verifikation digitaler Schaltungen mit einer großen Zahl von Zuständen bekannt.

Die Erfindung betrifft ein Verfahren zur Verifikation datenverarbeitender Systeme, insbesondere digitaler Schaltungen, welche auf der symbolischen Darstellung boolescher Funktionen mit Hilfe binärer Entscheidungsdiagramme basiert. Der Erfindung liegt die Aufgabe zugrunde, ein Verfahren zur Verifikation datenverarbeitender Systeme, insbesondere digitaler Schaltungen anzugeben, welches in der Lage ist, nicht nur kombinatorische, sondern auch sequentielle Systeme großer Komplexität zu verifizieren und damit die Probleme der zum Stand der Technik bekannten Verfahren zu überwinden. Diese Aufgabe wird mit Hilfe eines Verfahrens zur Verifikation datenverarbeitender Systeme, insbesondere digitaler Schaltungen, mit Merkmalen nach Anspruch 1 gelöst.

Dieses Verfahren basiert ebenfalls wie das aus dem Stand der Technik bekannte Verfahren auf dem Vergleich zweier unabhängig voneinander erstellter formaler Beschreibunoen eines zu verifizierenden Systems, z.B. der mit Hilfe einer Hardware-Beschreibungssprache formulierten Systemspezifikation und der z.B. in Form einer Netzliste vorliegenden Schaltungsimplementierung. Das erfindungsgemäße Verfahren bedient sich einer speziellen Darstellung boolescher Funktionen mit Hilfe binärer Entscheidungsdiagramme. Diese spezielle und vorteilhafte Darstellung boolescher Funktionen ermöglicht die Durchführung des Vergleichs beider Systembeschreibungen mit Hilfe einer Fixpunktiteration, mit deren Hilfe nicht äquivalente Zustände der beiden Systembeschreibungen aufgefunden werden. Dazu werden die beiden miteinander zu vergleichenden Systembeschreibungen als Mealy-Automaten modelliert. Mit Hilfe einer Fixpunkt-Iteration wird die Menge der nicht-äquivalenten Zustände der beiden Mealy-Automaten in Form binärer Entscheidungsdiagramme dargestellt. Zur Durchführung der Fixpunktiteration werden die Ausgangsund Übergangsfunktionen der beiden Mealy-Automaten ebenfalls durch binäre Entscheidungsdiagramme dargestellt.

Die erfindungsgemäße Form der Darstellung durch binäre Entscheidungsdiagramme bewirkt eine äußerst effiziente Speicherung der Datenstrukturen des Verfahrens und ermöglicht eine Beschränkung der zur Durchführung des Verfahrens notwendigen Operationen auf einfache Substitutionen und Boolesche Operationen auf binären Entscheidungsdiagrammen. Hierdurch wird das Verfahren für technisch interessierende Systeme überhaupt erst praktisch anwendbar.

Das erfindungsgemäße Verfahren kann auf datenverarbeitende Systeme verschiedener Art, wie z.B. auf digitale Schaltungen, Kommunikationsprotokolle, Computerprogramme und Mikroprogramme zu deren Verifikation angewendet werden. Jedes technische System, welches als Mealy-Automat modelliert werden kann, kann mit Hilfe des Verfahrens verifiziert werden.

Vorteilhafte Weiterbildungen der Erfindung ergeben sich aus den Unteransprüchen.

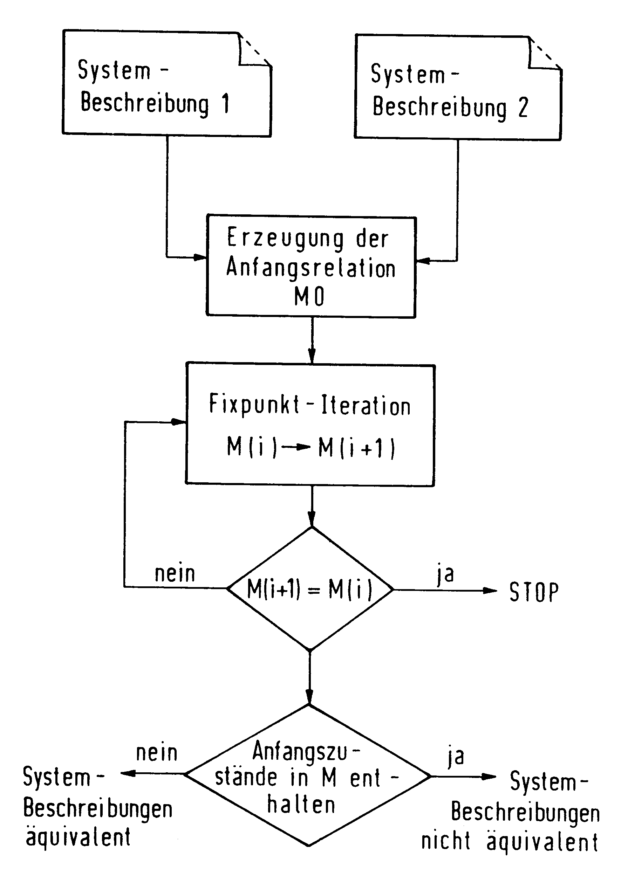

Figur 1 zeigt ein Ablaufdiagramm des Verfahrens.

Im folgenden wird die Erfindung anhand eines speziellen Ausführungsbeispiels näher beschrieben. Aus Gründen der besseren Verständlichkeit werden die wichtigsten grundlegenden hierzu benötigten Begriffe am Anfang erläutert. Im übrigen sind die hier verwendeten Begriffe und Bezeichnungsweisen dem Fachmann auf diesem Gebiet geläufig und können z.B. in den Veröffentlichungen von W. Brauer, "Automatentheorie", B.G. Teubner, 1964 oder Z. Kohavi, "Switching and Finite Automata Theory", McGraw-Hill Book Edition, 1978, entnommen werden.

Bei synchronen sequentiellen Digitalschaltungen werden alle Elemente mit internen Zuständen, wie z.B. Flip-Flops, Latches, Register und speichernde Elemente mit Hilfe eines globalen Clocksignals getriggert, sodaß alle Elemente ihren Zustand simultan bei einem Clocksignal-Übergang ändern. Der neue Zustand einer synchronen sequentiellen Digitalschaltung hängt dabei ausschließlich von ihrem momentanen Zustand und den Werten der Eingangssignale ab. Damit hängen auch die Ausgangssignale der Digitalschaltung nur von den Eingangssignalen und dem internen Zustand dieser Schaltung ab. Aus diesem Grunde kann das Verhalten einer synchronen sequentiellen Digitalschaltung durch das Modell des endlichen Automaten (finite state machine), genauer als Mealy-Automat modelliert werden (Z.Kohavi, 1978, W.Brauer, 1984). Sowohl die Spezifikation einer synchronen sequentiellen Digitalschaltung als auch ihre Implementierung kann daher als Mealy-Automat aufgefaßt werden. Dabei wird die Implementierung einer solchen Digitalschaltung häufig in Form einer sog. Netzliste vorliegen. Die Spezifikation kann vorteilhaft mit Hilfe einer Übergangstabelle oder einer geeigneten Hardware-Beschreibungssprache geschehen. Eine synchrone seauentielle Digitalschaltung zu verifizieren bedeutet, eine Implementierung dieser Schaltung mit ihrer Spezifikation zu vergleichen. Wegen der Modellierbarkeit beider Beschreibungen durch Mealy-Automaten läßt sich dieses Problem auf den Vergleich zweier unterschiedlich beschriebener Mealy-Automaten reduzieren. Die folgenden Definitionen endlicher deterministischer Mealy-Automaten und der Äquivalenz zwischen zwei Mealy-Automaten sind in der Automatentheorie (Z.Kohavi, 1978; W.Brauer, 1984) üblich. Der besseren Verständlichkeit halber werden diese Definitionen hier kurz zusammengestellt.

Ein endlicher deterministischer Mealy-Automat ist durch die Angabe eines Alphabetes von Eingangsgrößen, einer endlichen Menge von Zuständen, eines Alphabetes von Ausgangsgrößen, einer Ausgangsfunktion, welche jedem Wert der Eingangsgrößen und der Zustände einen Wert der Ausgangsgrößen zuordnet, einer Übergangsfunktion, welche jedem Eingangswert und Zustand einen Zustand zuordnet, sowie eines anfänglichen Zustandes gegeben.

Ein deterministischer Mealy-Automat definiert eine partielle Abbildung, welche jedem Wort aus Elementen des Alphabets von Eingangsgrößen ein Wort aus Elementen des Alphabets der Ausgangsgrößen zuordnet. Wird dem Automaten eine Folge von Eingangsgrößen eingegeben, so wird dieser Folge eine Folge von Ausgangsgrößen zugeordnet, wobei zunächst aus den Eingangsgrössen mit Hilfe der Übergangsfunktion neue Zustandsgrößen und daraufhin aus den Zustandsgrößen und den Eingangsgrößen mit Hilfe der Ausgangsfunktion die neuen Ausgangsgrößen berechnet werden. Betrachtet man den Automaten von außen, so sind diese Zuordnungen das einzige was über sein Verhalten beobachtet werden kann und es ist deshalb natürlich, zwei deterministische Mealy Automaten als äquivalent anzusehen, wenn sie ein übereinstimmendes Eingangs- und Ausgangsalphabet haben und wenn ihre oben beschriebenen Zuordnungen äquivalent sind. Die Abbildunc wird dabei als partiell bezeichnet, weil im allgemeinen die Übergangsfunktion und die Ausgangsfunktion nur partiell definierte Funktionen sind. Indem diese Funktionen vervollständigt werden, was z.B. in Z.Kohavi, 1978 beschrieben ist, kann das Problem des Vergleichs zweier unvollständig beschriebener Automaten auf einen Vergleich zweier vollständig beschriebener Automaten zurückgeführt werden. Im folgenden wird deshalb angnommen, daß die Ausgangs- und Übergangsfunktion vollständig definierte Funktionen sind, und es wird deshalb lediglich das Problem des Vergleichs zweier vollständiger deterministischer Mealy-Automaten betrachtet.

Zwei Zustände zweier deterministischer Mealy-Automaten mit übereinstimmenden Eingangs- und Ausgangsalphabeten heißen äquivalent genau dann, falls
a) die Werte ihrer Ausgangsfunktionen für diese beiden Zustände bei jeweils gleichen Eingangssignalen übereinstimmen und
b) für alle Werte der Eingangssignale, die sich aus ihren Übergangsfunktionen aus diesen Zuständen ergebenden Zustände bei jeweils gleichen Eingangssignalen äquivalent sind.

Zwei deterministische Mealy-Automaten mit gleichen Eingangs- und Ausgangsalphabeten heißen äquivalent dann und nur dann, wenn ihre Anfangszustände äquivalent sind.

Ein Standardverfahren zur Überprüfung der Äquivalenz zweier Mealy-Automaten wird in dem Aufsatz von Z.Kohavi 1978 beschrieben: Hierzu definiert man zu zwei Mealy-Automaten mit identischen Eingangs- und Ausgangsalphabeten den Produktautomaten, indem man als Eingangsalphabet des Produktautomaten das den beiden ursprünglichen Mealy-Automaten zugrundeliegende gemeinsame Eingangsalphabet verwendet, die Menge der Zustände des Produktautomaten gleich dem kartesischen Produkt der Zustandsmenge der Ausgangsautomaten wählt, das Ausgangsalphabet des Produktautomaten aus den beiden booleschen Werten "wahr" bzw. "falsch" bestehen läßt, der Ausgangsfunktion des Produktautomaten den Wert "wahr" zuweist, falls die Ausgangsfunktionen der ursprünglichen Automaten übereinstimmen, der Ausgangsfunktion des Produktautomaten den Wert "falsch" zuweist, falls die Ausgangsfunktionen der ursprünglichen Automaten nicht übereinstimmen, und der Übergangsfunktion des Produktautomaten die aus den Werten der Übergangsfunktionen der ursprünolichen Automaten gebildeten Zweitupel zuweist. Mit Hilfe dieser Definition können die beiden Definitionen über die Äquivalenz zweier Zustände zweier deterministischer Mealy-Automaten sowie die Definition über die Äquivalenz von MealyAutomaten wie folgt formuliert werden:
Die Äquivalenzrelation zwischen Zuständen zweier deterministischer Mealy-Automaten ist die größte Relation auf dem kartesischen Produkt der beiden Zustandsräume zweier Mealy-Automaten mit der folgenden Eigenschaft:
Ein Element des Produkt-Zustandsraums gehört zur Relation dann und nur dann, falls für alle Eingangswerte gilt:
Die Ausgangsfunktion des Produktautomaten nimmt für dieses Element des Produktzustandsraums den Wert "wahr" an und das Bild der Übergangsfunktion gehört ebenfalls zur Relation. Zwei deterministische mealy-Automaten heißen dann äquivalent dann und nur dann, falls sämtliche aus den Anfangszuständen dieser beiden Automaten gebildeten Zustände des Produktzustandsraums zu dieser Äquivalenzrelation gehören.

Die bekannten Verfahren (O.Coudert, Ch. Berthet, J.Ch. Madre, "Verification of sequential machines using boolean functional vectors", in IMEC-IFIP International Workshop on Applied Formal Methods For Correct VLSI Design, 1989; S.Devadas, Hi-Keung Tony Ma, R. Newton, "On the verification of sequential machines at differing levels of abstraction", IEEE-Transactions on Computer-Aided Design, 7(6): 713-722, 1988; K.J.Supovit, S.J. Friedman, "A new method for verifying sequential circuits, in 23rd ACM/IEEE Design Automation Conference, 1986) zur Überprüfung der Äquivalenz zweier synchroner sequentieller Schaltkreise (Mealy-Automaten) gehen von einem Anfangszustand des Produktautomaten aus, und suchen nach einem Übergang bei dem die Ausgangsfunktion des Produktautomaten den Wert falsch annimmt, wodurch ein Unterschied im Ausgangsverhalten der beiden ursprünglichen Maschinen signalisiert wird. Falls kein solcher Übergang gefunden wird, nachdem der gesamte erreichbare Zustandsraum der Produktmaschine abgearbeitet worden ist, ist die Äquivalenz der ursprünglchen Mealy-Automaten und damit der zu vergleichenden synchronen sequentiellen Schaltungen bewiesen.

Die explizite Konstruktion des Zustandsdiagramms (K.H.Supovit, S.J.Friedman 1986) des Produktautomaten ist ein sehr speicherverzehrender Vorgang und kommt daher nur zur Verifikation mit Automaten mit nur sehr wenigen Zuständen, wie sie z.B. zu Kontrollschaltungen gehören, in Betracht. Andere Verfahren (O.Coudert, et al, 1989) untersuchen den Produktautomaten ohne sein Zustandsdiagramm explizit zu konstruieren. Die Untersuchung des Produktautomaten beginnt mit einem Anfangszustand des Produktautomaten und bei jedem neuen Zustand wird überprüft, ob kein Übergang den Ausgang falsch erzeugt, wodurch ein unterschiedliches Verhalten der ursprünglichen Automaten angezeigt würde. Bei einer derartigen Untersuchung des Produktautomaten bieten sich grundsätzlich zwei verschiedene Stratetgien zur Buchführung über alle erzeugten Zustände an:
Die erste Strategie kann als depth-first Strategie bezeichnet werden (S.Devadas, et, 1988). Diese Strategie hat den Nachteil, daß ihre Komplexität linear mit der Zahl der erreichbaren Zustände wächst. Aus diesem Grunde können mit Hilfe dieser Strategie nur Automaten mit einer sehr kleinen Zahl von Zuständen (z.B. 2764 in dem Beispiel in dem Aufsatz von S.Devadas, et al, 1988) verglichen werden. Die zweite mögliche Strategie kann als breadth-first Strategie bezeichnet werden (O.Coudert, et al, 1989). Bei dieser Strategie werden in einem Schritt mehrere Zustände anstelle nur eines Zustandes, wie bie der depth-first Strategie behandelt, so daß diese Strategie von einer effizienten Darstellung von Mengen mit Hilfe binärer Entscheidungsdiagramme profitieren kann (R.E.Bryant, "Graph-based algorithmus for boolean function manipulation", IEEE Transactions Computer, C-35 (12): 1035-1044, 1986). Die Vorzüge dieses Verfahrens sind mit Hilfe von Beispielen demonstriert worden, bei denen Automaten mit bis zu 22 Mill. Zuständen verifiziert worden sind. Trotzdem wächst die Komplexität einer breadth-first Untersuchung linear mit der Länge des längsten Zyklus im erreichbaren Teil der Produktmaschine, und deshalb kann eine recht große Klasse interessanter Automaten, wie z.B. Zähler, nicht mit Hilfe eines solchen Verfahrens verglichen werden. Ein anderes Problem des Verfahrens von Coudert et al besteht darin, daß zu der Durchführung dieses Verfahrens zwischen verschiedenen Darstellungen gewechselt werden muß und daß der Wechsel zwischen diesen Darstellungen Operationen mit exponentieller Komplexität erfordert.

Um die Probleme, welche mit der Abarbeitung des erreichbaren Zustandsraumes eines Produktautomaten und der adäquaten Darstellung von Mealyautomaten einhergehen, zu überwinden, wird ein anderes Verfahren verwendet. Aus der Definition der Äquivalenz zweier Zustände bzw. der Äquivalenz zweier Mealyautomaten geht hervor, daß für den Fall, daß zwei nicht äquivalente Zustände existieren es eine endliche Eingangssequenz geben muß, für welche sich die zugehörigen Ausgangssequenzen der beiden Mealyautomaten unterscheiden. Es wird daher angenommen, daß in den meisten praktisch interessierenden Fällen eine recht kurze Eingangssequenz existiert, welche diese Eigenschaft hat, da, wenn zwei Zustände nicht äquivalent sind, dies nach einer kurzen Zeit bei Verwendung einer geeigneten Eingangssequenz am Ausgang beobachtbar sein sollte. Anstelle also den gesamten erreichbaren Zustandsraum zu erzeugen und die Äquivalenz aller Zustände zu überprüfen, wie dies bei den Verfahren aus der Literatur geschieht, wird bei dem erfindungsgemäßen Verfahren die gesamte Relation der nicht äquivalenten Zustände, d.h. das Komplement der Menge der äquivalenten Zustände auf dem Produktraum der Zustände berechnet. Die Berechnung wird mittels einer Fixpunkt-Iteration durchgeführt, in der nur einfache Operationen auf binären Entscheidungsdiagrammen benötigt werden.

Zur Durchführung dieser Iteration betrachtet man als Ausgangspunkt die Menge aller Zustandspaare, d.h. die Menge aller Zustände des Produktautomaten der zu überprüfenden Mealy-Automaten, welche unterschiedliche Ausgangswerte für mindestens ein Eingangsmuster haben. Diese Ausgangsmenge wird nun schrittweise um diejenigen Zustandspaare erweitert, für welche gilt, daß von ihnen aus unter Anwendung der Übergangsfunktionen der zu verifizierenden Mealyautomaten bzw. der Übergangsfunktion des Produktautomaten die Zustandspaare der Ursprungsmenge in endlich vielen Schritten unter Annahme geeigneter Eingangsmuster erreicht werden können. Diese Iteration endet, falls die dabei erzeugte Menge von Zustandspaaren sich nicht mehr ändert, falls also ein Fixpunkt erreicht wird. Es ist klar aus der Definition der Äquivalenz von Mealyautomaten, daß diese Fixpunktmenge die Menge aller nicht äquivalenten Zustände ist.

Es handelt sich also um alle nicht äquivalenten Zustandspaare der zu vergleichenden Mealyautomaten. Diese sind nun äquivalent, falls ihre Anfangszustände äquivalent sind. Es bleibt also lediglich zu prüfen, ob die Anfangszustände der zu vergleichenden Mealyautomaten bzw. die aus diesen Zuständen gebildeten Zustandspaare Elemente der erzeugten Fixpunktmenge sind oder nicht. Dieses Verfahren hat den Vorteil, daß in allen praktisch untersuchten Fällen die Fixpunktmenge bereits nach sehr wenigen Schritten konstruiert ist. Daneben hat dieses Verfahren den Vorteil, daß alle zur Konstruktion der Fixpunktmenge nötigen Operationen sehr effizient mit Hilfe binärer Entscheidungsdiagramme realisiert werden können. Diese werden in dem Aufsatz von Bryant 1986 detailliert beschrieben (R.E. Bryant, "Graph based algorithmus for boolean function manipulation", IEEE Trans. Computer, C-35 (12): 1035-1044, 1986).

Bei synchronen sequentiellen Digitalschaltungen sind die Zustände und Eingangs- bzw. Ausgangssignale der diese Schaltkreise modellierenden Mealyautomaten boolesche Vektoren und die Ausgangs- und Übergangsfunktionen sind als vektorwertige boolesche Funktionen definiert, deren Argumente boolesche Vektoren sind. Zur Darstellung solcher booleschen Funktionen und der Operationen auf ihnen wurden von Bryant (R.E.Bryant 1986) die binären Entscheidungsdiagramme (BODS) eingeführt. Binäre Entscheidungsdiagramme haben vorteilhafte Eigenschaften nur für bestimmte Klassen boolescher Funktionen, da die Größe eines binären Entscheidungsdiagramms, welches eine boolesche Funktion darstellt, schlimmstenfalls eine exponentiell wachsende Funktion der Zahl der Argumente dieser booleschen Funktion ist. Andererseits haben empirische Untersuchungen ergeben, daß boolesche Funktionen, welche durch kombinatorische oder sequentielle Digitalschaltungen realisiert werden, kompakte Darstellungen durch binäre Entscheidungsdiagramme haben und daß binäre Entscheidungsdiagramme vorteilhaft zur Darstellung sequentieller Digitalschaltungen eingesetzt werden können.

In dem oben beschriebenen Fixpunktiterationsverfahren zur Erzeugung der Relation der nicht äquivalenten Zustände zweier Mealyautomaten wird eine Methode zur Darstellung der Mengen, welche im Laufe des Fixpunktiterationsverfahrens erzeugt werden benötigt. Diese Mengen sind Relationen über dem kartesischen Produkt der Zustandsräume beider Mealyautomaten, d.h. Teilmengen eines binären Einheitswürfels entsprechender Dimensionen. Jede Teilmenge U eines k-dimensionalen binären Würfels kann durch ihre charakteristische Funktion beschrieben werden, welche jedem Punkt des binären Würfels, welcher zugleich Element der Menge U ist, den Wert 1 zuordnet und allen anderen Elementen des Würfels den Wert 0. Dabei entspricht die charakteristische Funktion einer Durchschnittsmenge zweier Mengen der UND-Verknüpfung beider charakteristischen Funktionen dieser Mengen, die charakteristische Funktion einer Vereinigungsmenge der ODER-Verknüpfung und die charakteristische Funktion einer Differenzbildung der UND-Verknüpfung der charakteristischen Funktionen der Ausgangsmenge mit der charakteristischen Funktion des Komplements der subtrahierten Menge. In dem Aufsatz von J.R.Burch, et al, "Sequential circuit verification using symbolic model checking", in ACM/IEEE Desgin Automation Conference, 1990, wird anstelle der Übergangsfunktion die entsprechende Übergangsrelation zur Modellierung einer synchronen sequentiellen Digitalschaltung verwendet. Diese Übergangsrelation wird mit Hilfe eines binären Entscheidungsdiagramms der charakteristischen Funktion dieser Übergangsrelation dargestellt. Empirische Untersuchungen haben gezeigt, daß die Darstellung synchroner sequentieller Digitalschaltungen und kombinatorischer Digitalschaltungen mit Hilfe funktionaler Vektoren binärer Entscheidungsdiagramme Vorteile gegenüber einer Darstellung in Form von charakteristischen Funktionen hat, da sie offenbar in der Lage ist, Schaltkreise höherer Komplexität darzustellen.

Auf der Basis der Darstellung von Mealyautomaten und Relationen mit Hilfe von booleschen Funktionen und damit durch binäre Entscheidungsdiagramme wird nun die Realisierung des Fixpunktiterations verfahrens zur Berechnung der Relation der nicht äquivalenten Zustände zweier Mealyautomaten beschrieben. Der erste Schritt zur Vorbereitung der Fixpunktiteration besteht in der Berechnung der Ausgangsrelation MO, zu welcher alle Zustandspaare, welche aus zwei Zuständen der beiden Mealyautomaten gebildet sind, gehören, für welche gilt, daß mindestens ein Eingangssignal existiert, für welches die Ausgangsfunktionen der beiden Mealyautomaten für die beiden Zustände verschiedene Werte annehmen. Sind die Ausgangsfunktionen der beiden Mealyautomaten als Vektoren binärer Entscheidungsdiagramme gegeben, kann die charakteristische Funktion der Ausgangsrelation einfach berechnet werden.

Dazu werden aus den Vektoren von binären Entscheidungsdiagrammen für die Ausgangsfunktionen für jeden einzelnen Ausgang die zugehörigen binären Entscheidungsdiagramme "EXOR" verknüpft. Für jeden Ausgang wird also ein binäres Entscheidungsdiagramm berechnet, welches für genau die Zustandspaare und Eingangssignale den Wert "wahr" liefert für die dieser Ausgang in beiden Mealyautomaten einen unterschiedlichen Wert liefert. Auf jedes dieser binären Entscheidungsdiagramme wird anschließend ein Existenzoperator bezüglich der Eingänge angewandt. Ein so berechnetes binäres Entscheidungsdiagramm gibt genau für die Paare von Zuständen den Wert "wahr", für welche mindestens ein Eingabesignal existiert, so daß das ursprüngliche binäre Entscheidungsdiagramm den Wert "wahr" liefert, also der Ausgang einen unterschiedlichen Wert liefert. Der Existenzoperator auf einem binären Entscheidungsdiagramm bezüglich einer Menge von Eingängen kann sukzessive durch den Existenzoperator bezüglich eines einzelnen Eingangs berechnet werden. Dazu wird auf das ursprüngliche binäre Entscheidungsdiagramm der Existenzoperator bezüglich des ersten Eingangs berechnet. Auf das entstandene binäre Entscheidungsdiagramm wird der Existenzoperator bezüglich des zweiten Eingangs berechnet. Dieses Verfahren wird bis zum letzten Eingang fortgesetzt. Zur Berechnung eines Existenzoperators bezüglich eines Eingangs wird in dem binären Entscheidungsdiagramm der Eingang durch "wahr" bzw. "falsch" substituiert und die beiden entstehenden binären Entscheidungsdiagramme werden "ODER" verknüpft. Der Existenzoperator ist also auf einfache Substitution und "ODER"-Verknüpfung zurückführbar. Nach Anwendung des Existenzoperators werden die für die einzelnen Ausgänge entstandenen binären Entscheidungsdiagramme noch alle "ODER" verknüpft und das Ergebnis ist ein binäres Entscheidungsdiagramm, welches die charakteristische Funktion für MO darstellt. Eine explizite Berechnung der Zwischenergebnisse ist nicht unbedingt erforderlich, sondern die gesamte oben beschriebene Berechnung von MO aus den Vektoren von binären Entscheidungsdiagrammen für die Ausgangsfunktionen kann auch zu einem einzigen Schritt verschmolzen werden.

Die Ausgangsrelation MO ist der Ausgangspunkt der Fixpunktiteration, welche aus der Ausgangsrelation weitere Relationen berechnet.

Während des Ablaufs des Iterationsverfahrens wird die charakteristische Funktion der zwischendurch auftretenden Relationen M(i) aus den vorhergehenden charakteristischen Funktionen durch folgende Schritte berechnet:

In dem binären Entscheidungsdiagramm der charakteristischen Funktion für M(i) werden die Zustände durch die binären Entscheidungsdiagramme ihrer Zustandsübergangsfunktionen ersetzt. Dies entspricht der Substitution von Variablen in binären Entscheidungsdiagrammen durch binäre Entscheidungsdiagramme. Das berechnete binäre Entscheidungsdiagramm gibt für jedes Paar von Zuständen und jedes Eingabesignal genau dann den Wert "wahr", wenn die Nachfolgezustände der betrachteten Zustände unter der Wirkung der Übergangsfunktion der Mealy-Automaten die Eigenschaft haben, daß die charakteristische Funktion der Relation M(i) dieses Iterationsschrittes den Wert "wahr" besitzt. Auf das berechnete binäre Entscheidungsdiagramm wird der Existenzoperator bezüglich der Eingangssignale angewandt und das Ergebnis mit dem binären Entscheidungsdiagramm der charakteristischen Funktion der Relation M(i) "ODER" verknüpft. Die Relation M(i) wird also um genau die Paare von Zuständen erweitert, für welche mindestens ein Eingabesignal existiert, so daß die Nachfolgezustände in der Relation M(i) enthalten sind. Zur Durchführung des Iterationsschrittes sind also lediglich Einsetzung, d.h. Substitution, und "ODER"-Verknüpfung auf binären Entscheidungsdiagrammen erforderlich, da der Existenzoperator wie vorherbeschrieben auf Substition und "ODER"-Verknüpfung zurückgeführt werden kann. Eine explizite Berechnung der Zwischenergebnisse ist nicht unbedingt erforderlich, sondern die gesamte oben beschriebene Berechnung kann zu einer einzigen Operation verschmolzen werden.

Im Effekt sind diese Operationen gleichwertig zu einer Vereinigung von Teilmengen des Produktzustandsraumes, bei der die Menge M(i), welche die Relation dieses Iterationsschrittes repräsentiert, mit der Menge der Vorgänger-Zustandspaare unter der Wirkung der Übergangsfunktionen der zu vergleichenden Mealy Automaten vereinigt wird, um die Menge M(i+l) zu erhalten, welche die Relation des nachfolgenden Iterationsschrittes repräsentiert.

Das Iterationsverfahren bricht ab, wenn ein Iterationsschritt zu keiner Veränderung der Relation führt. Um dies festzustellen, ist ein einfacher Vergleich zweier aufeinander folgender binärer Entscheidungsdiagramme, welche die charakteristischen Funktionen der Relationen darstellen, erforderlich.

Die zu vergleichenden Mealy-Automaten sind dann äquivalent, wenn ihre Anfangszustände nicht zur Relation M der nichtäquivalenten Zustände gehören.

Die Kombination der Darstellung von Mealyautomaten mit Hilfe von Vektoren von Funktionen, d.h. binärer Entscheidungsdiagramme, und der Darstellung von Mengen durch ihre charakteristischen Funktionen kann mit Hilfe der obigen Substitionen einfach und elegant ausgeführt werden. Das Verfahren von Coudert et al (O.Coudert 1989) benötigt eine explizite Überführung der beiden Darstellungen ineinander, obwohl damit Operationen von exponentieller Komplexität verbunden sind. Das Iterationsverfahren kommt zum Stillstand, falls die erzeugten Mengen bzw. Relationen zwischen zwei Iterationschritten identisch sind. Diese Identität wird durch Auswertung der binären Entscheidungsdiagramme der charakteristischen Funktionen, welche diese Mengen repräsentieren durchgeführt.

Damit ist die Realisierung des gesamten Fixpunktverfahrens auf der Grundlage binärer Entscheidungsdiagramme beschrieben. Die einzigen Operationen auf binären Entscheidungsdiagrammen, welche innerhalb der Fixpunktiteration benötigt werden, sind die booleschen Funktionen "ODER" bzw. "ungleich" und die Ersetzung (Substitution) von Variablen boolescher Funktionen bzw. von Entscheidungsdiagrammen.

## Patentansprüche

1. Verfahren zur Verifikation datenverarbeitender Systeme, bei dem
a) zwei unabhängig voneinander erstellte Beschreibungen eines zu verifizierenden Systems als Mealy-Automaten repräsentiert und miteinander verglichen werden;
b) der Vergleich mit Hilfe eines Fixpunktiterationsverfahrens durchgeführt wird, welches zunächst die Menge MO aller Zustandspaare erzeugt, welche für mindestens einen Satz von Eingangswerten mindestens einen verschiedenen Ausgangswert erzeugen, und diese Menge MO um die Menge aller Zustandspaare, welche in endlich vielen Schritten der beiden Mealy-Automaten auf ein Zustandspaar führen, das der Menge MO angehört, iterativ erweitert bis die Fixpunktmenge M aller nicht äquivalenten Zustandspaare erzeugt ist, wobei die beiden Mealy-Automaten äquivalent sind, wenn ihre Anfangszustände bzw. die aus diesen Zuständen gebildeten Zustandspaare der Fixpunktmenge M nicht angehören;
c) Äquivalenzrelationen zwischen Zuständen, Ausgangs- und Übergangsfunktionen der beiden Mealy-Automaten durch binäre Entscheidungsdiagramme dargestellt werden; und
d) in jedem Schritt der Fixpunktiteration lediglich boolesche Operationen und Substitutionen auf binäre Entscheidungsdiagramme angewendet werden.

2. Verfahren nach Anspruch 1,
bei dem die datenverarbeitenden Systeme digitale Schaltungen sind.

3. Verfahren nach Anspruch 2,
bei dem die zu verifizierende Digitalschaltung in Form zweier Netzlisten beschrieben ist.

4. Verfahren nach Anspruch 2,
bei dem die zu verifizierende Digitalschaltung in Form einer Netzliste und mit Hilfe einer Hardware-Beschreibungssprache beschrieben ist.

5. Verfahren nach Anspruch 1,
bei dem die datenverarbeitenden Systeme Kommunikationsprotokolle sind.

6. Verfahren nach Anspruch 1,
bei dem die datenverarbeitenden Systeme Computerprogramme sind.

7. Verfahren nach Anspruch 1,
bei dem die datenverarbeitenden Systeme Mikroprogramme sind.

## Claims

1. Procedure for verifying data-processing systems, in which
a) two descriptions, generated independently of one another, of a system to be verified are represented as Mealy automata and are compared with one another;
b) the comparison is carried out with the aid of a fixed-point iteration procedure which initially generates the set M0 of all state pairs which generate at least one different output value for at least one set of input values, and iteratively extends this set M0 by the set of all state pairs which, in a finite number of steps of the two Mealy automata, lead to a state pair which belongs to the set M0, until the fixed-point set M of all non-equivalent state pairs is generated, the two Mealy automata being equivalent when their initial states or the state pairs formed from these states do not belong to the fixed-point set M;
c) equivalence relations between states, output and transition functions of the two Mealy automata are represented by binary decision diagrams; and
d) in each step of the fixed-point iteration, only boolean operations and substitutions are applied to binary decision diagrams.

2. Procedure according to Claim 1, in which the data-processing systems are digital circuits.

3. Procedure according to Claim 2, in which the digital circuit to be verified is described in the form of two network lists.

4. Procedure according to Claim 2, in which the digital circuit to be verified is described in the form of a network list with the aid of a hardware description language.

5. Procedure according to Claim 1, in which the data-processing systems are communication protocols.

6. Procedure according to Claim 1, in which the data-processing systems are computer programs.

7. Procedure according to Claim 1, in which the data-processing systems are microprograms.

## Revendications

1. Procédé de vérification de systèmes de traitement de données, selon lequel
a) on représente deux descriptions, établies indépendamment l'une de l'autre, d'un système à vérifier sous la forme d'automates de Mealy et on les compare entre elles;
b) on effectue la comparaison à l'aide d'un procédé d'itération à point fixe, qui fournit tout d'abord l'ensemble MO de toutes les paires d'états, qui produisent au moins une valeur initiale différente pour au moins un ensemble de valeurs d'entrée, et augmente de façon itérative cet ensemble MO, de l'ensemble de toutes les paires d'états, qui conduisent, en un nombre élevé fini d'étapes des deux automates de Mealy, à une paire d'états qui appartient à l'ensemble MO, jusqu'à ce que l'ensemble M à point fixe de toutes les paires d'états non équivalentes soit obtenue, les deux automates de Mealy étant équivalents lorsque leurs états initiaux ou les paires d'états, formées à partir de ces états, n'appartiennent pas à l'ensemble à point fixe M;
c) on représente des relations d'équivalence entre des états, des fonctions de sortie et des fonctions de transfert des deux automates de Mealy par des diagrammes de décision binaires; et
d) lors de chaque étape de l'itération à point fixe, on applique exclusivement des opérations booléennes et des substitutions à des diagrammes de décision binaires.

2. Procédé suivant la revendication 1, selon lequel les systèmes de traitement de données sont des circuits numériques.

3. Procédé suivant la revendication 2, selon lequel le circuit numérique à vérifier est décrit sous la forme de deux listes de réseau.

4. Procédé suivant la revendication 2, selon lequel le circuit numérique à vérifier est décrit sous la forme d'une liste de réseau et à l'aide d'un langage de description matériel.

5. Procédé suivant la revendication 1, selon lequel les systèmes de traitement de données sont des protocoles de communication.

6. Procédé suivant la revendication 1, selon lequel les systèmes de traitement de données sont des programmes d'ordinateurs.

7. Procédé suivant la revendication 1, selon lequel les systèmes de traitement de données sont des microprogrammes.
